# EUROPEAN PATENT APPLICATION

(11) **EP 0 589 519 A2**
(43) Date of publication of application: **30.03.1994**
(21) Application number: 93202677.6
(22) Date of filing: 16.09.1993
(51) Int. Cl.: G02F 1/136, H01L 21/84

(54) **Electronic device manufacture**

(30) Priority: 24.09.1992 GB 9220220
(71) Applicant: PHILIPS ELECTRONICS UK LIMITED, Croydon CR9 3QR (GB); Philips Electronics N.V., 5621 BA Eindhoven (NL)
(72) Inventor: Young, Nigel David, c/o Philips Research Lab., Redhill, Surrey RH1 5HA (GB)
(74) Representative: Stevens, Brian Thomas

(57) **Abstract**

Thin-film connection tracks and other circuit elements of a liquid-crystal display or other large-area electronic device on an insulating substrate are protected from damage by ESD (electrostatic discharge) during ion implantation and/or other stages in their manufacture, by providing an ESD path comprising conductive thin-film links (6) between the separate thin-film tracks (4). The tracks (4) and their links (6) may be of, for example, aluminium or a metal silicide. The ESD path is later removed by applying a pulse (8) between the linked tracks (4) to pass a sufficiently large current as to evaporate and break the links (6) by Joule heating.

## Description

This invention relates to methods of manufacturing an electronic device (for example, a liquid crystal display device) having an insulating substrate on which a plurality of thin-film circuit elements are formed together with thin-film connection tracks, and relates particularly to the protection of the thin-film device structure from a damaging electrostatic discharge. The invention also relates to electronic devices manufactured by such methods.

A method of this type is described in United States patent specification US-A-5 019 002, the whole contents of which are hereby incorporated herein as reference material. Because the thin-film circuit elements and their connections are formed on an insulating substrate it is found that, during their manufacture, they can be damaged easily by the build-up and discharge of electrostatic charge, for example arising by friction during handling or arising by ion implantation which may be used to form some of the regions of the circuit elements.

US-A-5 019 002 describes how a group of the thin-film connection tracks may be protected from a damaging electrostatic discharge (ESD) by connecting the tracks to a removable electrostatic discharge (ESD) path. The tracks are extended outwards into a scribe lane at the periphery of the substrate area where they are connected to an external ESD guard ring in the form of additional thin-film elements. This guard ring provides ESD protection during manufacture of the device and is removed at the end of the device manufacturing process by scribing and then detaching that periperal area of the substrate.

However, the provision of an ESD guard ring in a scribe lane requires more substrate area for a given device size, and this may create difficulties for the processing equipment and for process homogeneity across the device area. More importantly however, the present inventor has found that severe ESD damage of the thin-film circuit elements and their connection tracks can often occur by charge generation and build-up when removing such an ESD guard ring by mechanically scribing the insulating substrate with for example a conventional diamond tool. Even when laser scribing is used, damage may sometimes still occur, and considerable care is required in aligning and directing the laser beam.

US-A-5 019002 also discloses the provision of an internal ESD guard ring which is integrated within the active thin-film pattern area of the device. This internal guard ring is not subsequently removed, but reliance is placed instead on the electrical isolating effect of coupling transistors not being turned on by the normally low operating voltages of the device.

It is an aim of the present invention to provide a removable ESD path while avoiding the need to use scribing for its removal.

According to the present invention there is provided a method of manufacturing an electronic device having an insulating substrate on which a plurality of thin-film circuit elements are formed together with thin-film connection tracks, wherein a group of the thin-film tracks are connected to a removable electrostatic discharge path to protect the tracks from a damaging electrostatic discharge. In accordance with the present invention such a method is characterised in that the removable electrostatic discharge path comprises conductive thin-film links between the separate thin-film tracks of the group, and in that the discharge path is subsequently removed by applying an electrical pulse between the linked tracks to pass a sufficiently large current through the links as to evaporate and break these thin-film links by Joule heating.

Thus, such links provided in accordance with the invention can be integrated into the thin-film pattern of the device without requiring extra substrate area. After providing ESD protection during the manufacturing process, the links are simply removed electrically by being blown electrically like a fuse. The provision of the ESD path by integrating such links into the thin-film pattern of the device can be particularly advantageous for ESD protection during an ion implantation stage which may be used in the manufacture of the device. However it may also protect against static charge arising from handling.

The links may be removed by the device manufacturer before sale of the device, or they may be removed by the customer who would thus complete the manufacture of the device.

Both the links themselves and the linked tracks of the device may be formed from a common thin film. In this case, a higher electrical resistance of the links (as compared with the linked tracks) can simply be obtained by shaping the links to have a narrower width than the tracks. However, if desired, the links may be formed from one thin-film and the tracks may be formed from another thin-film which may be deposited either before or after the link film. Ideally the link material should have a low melting point, low specific heat, low latent heat of melting and low thermal conductivity. Thin film aluminium has proved particularly suitable and convenient since it is already often used in the thin-film connection tracks of large-area electronics devices. However, thin film silicon may also be used for the links, for example as doped polycrystalline silicon or silicided with a metal.

These and other features in accordance with the present invention are illustrated specifically in embodiments of the invention now to be described, by way of example, with reference to the accompanying diagrammatic drawings, in which:-
Figure 1 is a plan view of an electronic device having ESD protection links, and shown towards the final stage of its manufacture by a method in accordance with the present invention;
Figure 2 is an enlarged plan view of a group of linked connection tracks in a device such as the device of Figure 1 at a final stage in its manufacture;
Figure 3 is a cross sectional view of part of the device of Figures 1 and 2 at an earlier ion implantation stage in its manufacture;
Figure 4 is a cross sectional view of the part of the device of Figure 3 taken on the line IV-IV of Figure 3 and illustrating a possible modification during the implantation stage, and
Figure 5 is a plan view of a group of linked tracks in a device such as that of Figure 2 and illustrating a modification of the link shape.

It should be noted that all the drawings are diagrammatic and not drawn to scale. Relative dimensions and proportions of parts of the Figures have been shown exaggerated or reduced in size for the sake of clarity and convenience in the drawings. The same reference signs are generally used to refer to corresponding or similar features in the different embodiments.

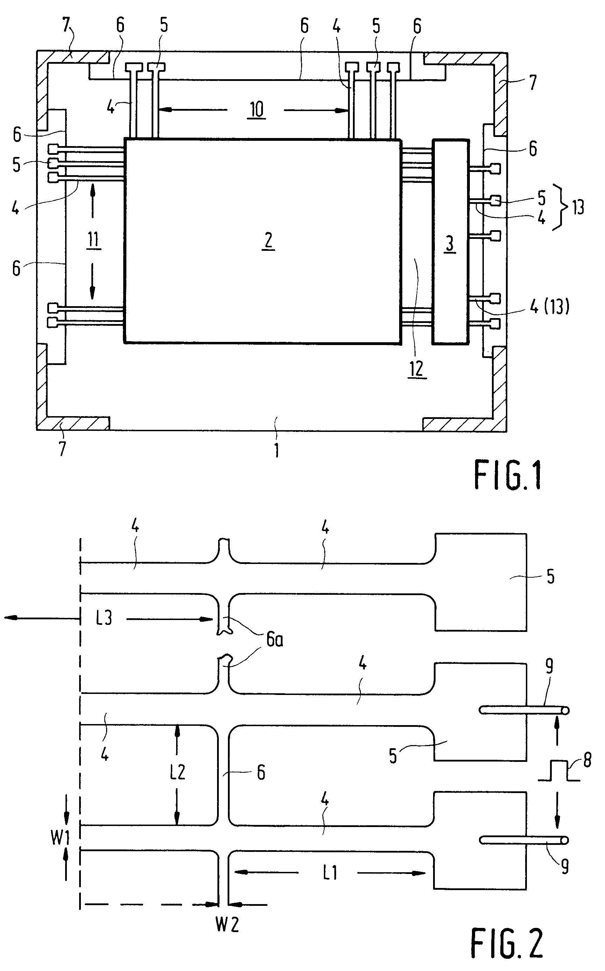

The present invention may be used in the manufacture of a wide variety of large-area electronics devices comprising thin-film device elements formed on an insulating substrate 1. Such a device as that of Figure 1 may be, for example, an active matrix liquid crystal display as described in, for example, US-A-5 019 002. Thus, the substrate 1 may be of an inexpensive glass providing a backplane of the display and carrying a matrix 2 of pixel switching elements (for example thin-film transistors) and associated driving circuitry 3 for the matrix 2. The individual circuit elements and connections of the matrix 2 and associated circuitry 3 may be formed in known manner, by depositing on the substrate 1 a succession of films of various materials (for example conductors, insulators, semiconductors, semi-insulators), the films being processed (for example by etching and doping) to form the various regions and patterns of the circuit elements and their connections. Figure 1 does not illustrate any circuit configuration for the matrix 2 and associated circuitry 3, because these may be in any variety of known forms, for example as described and illustrated in US-A-5 019 022.

However, instead of being an active matrix flat panel display, the device of Figure 1 may be designed for a quite different function, for example an image sensor having a switching matrix 2 which serves for addressing an array of thin-film image sensing elements (for example photodiodes) and which is driven by associated circuitry 3. In another form, the electronic device of Figure 1 may be a data store comprising a switching matrix 2 which serves for addressing an array of storage devices, for example thin-film capacitors.

In addition to the thin-film circuit elements and their immediate interconnections in the matrix 2 and circuitry 3, various groups 10 to 13 of thin-film connection tracks are present on the substrate 1. For convenience in the drawing, only some of the tracks 4 of each group 10 to 13 are shown in Figure 1. The tracks in groups 11 and 12 are row conductors of the matrix 2, and these may be of, for example, polycrystalline silicon or platinum silicide. Group 10 comprises column conductors of the matrix 2, and these may be of, for example, aluminium. Group 13 comprises external conductors for the circuitry 3 and may also be of aluminium. The outer ends of the tracks 4 of groups 10, 11 and 13 may be expanded to form contact pads 5 (see Figure 2); these pads 5 of the aluminium tracks 4 of groups 10 and 13 may serve as conventional bonding pads to which external wires (or other types of external connections) may be bonded.

In the absence of ESD provisions in accordance with the present invention, electrostatic charge may build up and damage the thin-film device elements during the manufacturing process, for example as described in US-A-5 019 022. In order to avoid damage by ESD (electrostatic discharge), the groups 10, 11 and 13 are provided with a removable ESD (electrostatic discharge) path in the form of conductive thin-film links 6 between the separate thin-film tracks 4 of the group, see Figures 1 and 2. Thus, instead of building up to a high potential on the separate individual tracks 4, the electrostatic charge is able to flow via the conductive links 6 so avoiding damaging discharges between the individual tracks 4. Indeed the linked track pattern may even be connected to a suitable potential, for example an earthing point, to effect a complete discharge.

These thin-film links 6 can be safely and easily removed in accordance with the present invention. The thin-film links 6 have a higher electrical resistance than the thin-film tracks 4 which they link, and they are removable by being blown in the manner of an electrical fuse. Figure 2 illustrates this removal stage in the manufacture. An electrical pulse 8 is applied between each pair of the linked tracks 4 to pass a sufficiently large current though the links 6 as to evaporate and break these higher-resistance links 6 by Joule heating. The link 6a in Figure 2 has already been broken in this manner, whereas the link 6 is in the course of having a pulse 8 applied. The links 6 and 6a in Figure 2 are formed from the same film as the tracks 4 but have a much narrower width W2. The external contact pads 5 provide a convenient area on each conductor 4 which can be contacted by a probe 9 to apply the pulse 8. The links 6 are close to the pads 5 and so the electrical resistance along the length L1 of each track 4 between the link 6 and the probe contact is low compared with the resistance of the narrrow link 6. When the pulse 8 is applied to pass a large heating current through the link 6, the current in the tracks 4 in the area of the active circuit elements is insufficient to adversely affect the circuit elements. The links 6 may be remote from the thin-film circuit elements of the matrix 2 and/or circuitry 3 so that the resistance of the link 6 is much smaller than the resistance along the tracks 4 to the active circuit elements. Furthermore, in many cases the active circuit elements do not provide any circuit connection between the pairs of conductor tracks 4, for example when the tracks 4 are connections to insulated gates of thin-film transistors in the circuitry 3 or matrix 2. Thus, the circuit elements do not affect and are not affected by the current flow from the probes 9 along the tracks 4 and through the links 6, even though these currents are much larger than those which flow during testing or normal operation of the device. If desired, the pulse for removing the links 6 may be applied via the probes 9 of a test equipment which is suitably adapted for this purpose.

In a typical example for the groups 10 and 13, the conductors 4 may be of aluminium having a width W1 of about 5µm (micrometres) or more. The aluminium links may have a width W2 of about 2µm or less and a length L2 of about 10µm between the linked tracks 4. The location of the links 6 along the tracks 4 may be such that, for example, the track length L1 between the link 6 and the contact pad 5 is about 20µm, whereas the remaining length L3 of the track 4 from the link 6 to the active circuit elements is typically at least 200µm. A pulse 8 of, for example, about 0.3 amps at 5 volts may be used to break these aluminium links 6. This high current level for blowing the links 6 can be contrasted with that (typically less than 10⁻³ amps) which flows along the tracks 4 during normal operation of the device.

An aluminium pattern such as that for the tracks 4 of the groups 10 and 13 is often provided in the latter stages of the device manufacture. However, a linked track pattern in accordance with the present invention may be incorporated in the manufacturing process at a much earlier stage. Sometimes, depending on the electronic device structure being manufactured, a thin-film conductor pattern may be formed on the substrate 1 as one of the initial patterns in the manufacture. In some electronic devices it is desirable to use ion implantation, for example to dope some semiconductor regions of some of the thin-film circuit elements so as to provide a desired conductivity type or a desired conductivity. Such ion implantation in the thin-film patterns on the insulating substrate 1 can result in damaging build-up and discharge of electrostatic charge from the ions, and the present invention may be used in avoiding this problem.

Thus, the thin-film circuit elements of the device of Figure 1 may comprise regions of a silicon film which is implanted at least locally with ions, the ion implantation being carried out after providing thin-film tracks and their links by patterning one or more thin films.

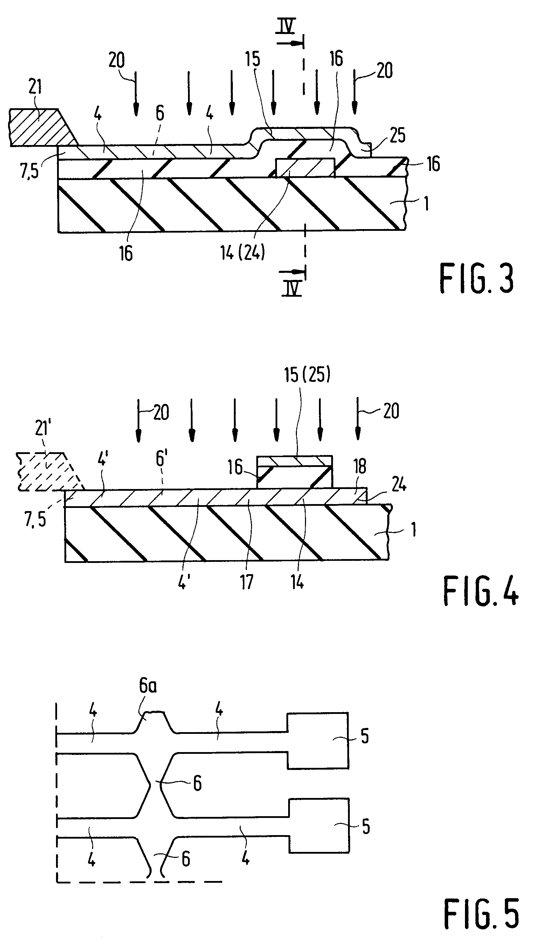

Figures 3 and 4 illustrate examples of such an ion implantation stage in which two silicon films 24 and 25 are implanted with ions 20 to form regions of circuit elements. The film 24 is patterned into circuit element regions 14,17,18 and possibly also into connection tracks 4'. The silicon film 25 is patterned into other circuit element regions 15 and the tracks 4 and links 6, and possible other circuit element regions. In the examples shown, the active circuit element being formed may be a field-effect transistor having a thin-film gate 15 (for example of a polycrystalline silicon film 25) which extends on a thin-film insulator 16 (for example of silicon dioxide) on a polycrystalline channel area 14 of the silicon film 24. In this case the ion implantation may be used to dope the gate 15 and the tracks 4 (and links 6) and to form doped source and drain regions 17 and 18 of of the transistor in the film 24; these sources and drain regions 17 and 18 are aligned with the gate 15 (and underlying channel area 14) due to the implantation mask effect of the gate. These tracks 4 may form part of the group 11 illustrated in Figure 1.

During the implantation stage of Figures 3 and 4, the silicon tracks 4 are linked together by the pattern of links 6 which constitutes a removable ESD (electrostatic discharge) path. The link pattern cannot be seen in the cross sections of Figure 3 and 4 but is illustrated in Figure 1. Via these links 6 and tracks 4, the charge accumulated by the silicon film 25 during the ion implantation is discharged to an earthing point in the implantation equipment. The substrate 1 may be held in the implantation equipment by a metal clip 21 bearing against the periphery of the substrate 1. Thus, the earthing of the thin film 14 during the implantation may be achieved simply by earthing the clip 21. The clip 21 may contact the expanded contact pads 5 at the ends of the tracks 4 and/or conductive corner pads 7 which can be linked to the tracks 4 by an extension of the links 6 as illustrated in Figure 1. The links 6 are subsequently broken in a final stage of the manufacture, by applying a pulse 8 as described previously.

Before applying the pulse 8, the silicon film 25 at least in the area of the group of tracks 4 and their links 6 (and preferably in all exposed areas, including the gates 15) may be silicided with a metal such as platinum, for example. Siliciding reduces the resistance of the tracks 4 (and links 6), which is of benefit for the normal operation of the device but which can also facilitate the electrical blowing of the links 6 by the pulse 8.

In many thin-film transistor circuit technologies, connections to the source and drain regions 17 and 18 are formed by metal tracks provided after the formation of the source and drain 17 and 18. However, at least some of the source and drain connections of some transistors may be silicon tracks 4' formed by patterning the film 24. Figure 4 illustrates such a modification, in which the tracks 4' are also linked to form an ESD path during the ion implantation stage of Figure 4. Thus, before the implantation, the film 24 may be patterned to provide not only the active areas 14,17,18 but also tracks 4' connected together by removable link 6' (not shown in the cross-section of Figure 4). The linked tracks 4' may be earthed via a clip 21' during the implantation. Subsequently the links 6' are broken by applying a pulse 8 as described previously.

In the example depicted in Figure 2, the links 6 were of uniform width throughout their length. However, the present inventor has found that sometimes such links 6 of uniform width may melt back into the tracks 4 when the links are blown by the pulse 8. This melt-back locally reduces the width of the track 4 and so increases the resistance of the track 4 or locally weakens the track 4. In order to avoid this melt-back, the links 6 may be shaped (for example, as illustrated in Figure 5) so as to have a width which increases adjacent to the tracks 4. In this case, when the link 6 is blown by the pulse 8, it is only the central narrowed part of the link 6 which is evaporated.

It will be evident to the person skilled in the design and manufacture of large-area electronic devices that many modifications and variations are possible within the scope of the present invention. Although it is particularly convenient to form the links 6 as an integral part of the same thin-film pattern as the tracks 4, the links 6 may be formed from a different thin-film which may be deposited before or after the thin-film providing the tracks 4. In this case, the link film may be patterned simultaneously with the track film, or in a separate stage. It is also possible for the track 4 to comprise more than one thin-film and in this case the links 6 may be formed in one of the constituent films of the tracks 4.

In the device of Figure 1, the provision of links 6 has been described for the tracks 4 of groups 10, 11 and 13. However the tracks of group 12 may also be provided with fusible links 6 for ESD protection. In this case, the pulse 8 for blowing these links may be applied via probes 9 directly contacting the tracks, or the tracks may have locally expanded contact areas for the probes 9.

From reading the present disclosure, other variations and modifications will be apparent to persons skilled in the art. Such variations and modifications may involve equivalents and other features which are already known in the design, manufacture and use of thin-film electronic devices and component parts thereof, and which may be used instead of or in addition to features already described herein. Although claims have been formulated in this application to particular combinations of features, it should be understood that the scope of the disclosure of the present application also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention. The applicants hereby give notice that new claims may be formulated to such features and/or combinations of such features during the prosecution of the present application or of any further application derived therefrom.

## Claims

1. A method of manufacturing an electronic device having an insulating substrate on which a plurality of thin-film circuit elements are formed together with thin-film connection tracks, wherein a group of the thin-film tracks are connected to a removable electrostatic discharge path to protect the tracks from a damaging electrostatic discharge, characterised in that the removable electrostatic discharge path comprises conductive thin-film links between the separate thin-film tracks of the group, and in that the discharge path is subsequently removed by applying an electrical pulse between the linked tracks to pass a sufficiently large current through the links as to evaporate and break these thin-film links by Joule heating.

2. A method as claimed in claim 1, further characterised in that a common film is patterned to form both the linked tracks and the links, and the links have a narrower width than the linked tracks.

3. A method as claimed in claim 2, further characterised in that the group of tracks and their links are of aluminium, the links having a width of at most about 2 micrometres over at least a part of their length, and the tracks having a width of at least 5 micrometres.

4. A method as claimed in claim 2 or claim 3, further characterised in that the links have a width which increases adjacent to the tracks.

5. A method as claimed in any one of the preceding claims, further characterised in that the thin-film circuit elements comprise regions of a silicon film which is implanted at least locally with ions, the ion implantation is carried out after providing the thin-film tracks and their links, and the charge accumulated by the thin-film parts on the substrate during the ion implantation is discharged to an earthing point in the ion implantation equipment via the links and tracks.

6. A method as claimed in claim 5, further characterised in that the group of tracks and their links are parts of the silicon film which is implanted with the ions.

7. A method as claimed in claim 6, further characterised in that the silicon film in at least the area of the group of tracks and their links is silicided with a metal before applying the pulse to break the links.
